# EUROPEAN PATENT APPLICATION

(11) **EP 4 549 719 A1**
(43) Date of publication of application: **07.05.2025**
(21) Application number: 24205110.0
(22) Date of filing: 07.10.2024
(51) Int. Cl.: F02C 9/00

(54) **SYSTEM AND METHOD FOR TURBINE ENGINE PARAMETER SYNTHESIS**

(30) Priority: 30.10.2023 US 202318497393
(71) Applicant: Honeywell International Inc., Charlotte, NC 28202 (US)
(72) Inventor: DAWSON, Dylan, Charlotte, 28202 (US); HAUGLAND, Ronnie, Charlotte, 28202 (US); WENIG, John, Charlotte, 28202 (US)
(74) Representative: Lucas, Peter Lawrence

(57) **Abstract**

A method includes: receiving a plurality of measurable engine parameters captured using aerial vehicle sensors; reading an estimated parameter value from each of a plurality of thermodynamic surface maps, wherein the plurality of thermodynamic surface maps have a first dimension comprising a first thermodynamic engine parameter, a second dimension comprising a second thermodynamic engine parameter, and a third dimension comprising a third thermodynamic engine parameter whose value is related to the first thermodynamic engine parameter and the second thermodynamic engine parameter, wherein the estimated parameter values are read from the third thermodynamic engine parameter from each of a plurality of thermodynamic surface maps based on selected values for a first thermodynamic engine parameter and a second thermodynamic engine parameter; estimating an unmeasured temperature value based on the estimated parameter values read from the plurality of thermodynamic surface maps; and controlling the turbine engine based on the estimated unmeasured temperature value.

## Description

### TECHNICAL FIELD

The present disclosure generally relates to turbine engine systems, and more particularly relates to measurement systems and methods for turbine engine systems.

### BACKGROUND

Gas turbine engines are used to power modern passenger and military aircraft. In gas turbine engines, the turbine is often required to operate in high temperature conditions at or exceeding melting temperatures of the turbine materials. The high temperature can enable greater turbine work/power extraction opportunity and thus technology to increase turbine temperature is a high priority for engine manufacturers. High temperatures, however, can affect the life of gas turbine engines, and resultingly turbine temperature limits can be imposed on gas turbine engines.

Actual turbine temperature and/or other engine parameter measurement values when the turbine is operating at high temperature may not be capable of being measured because the turbine environment can exceed the maximum operating temperature for measurement devices. Because of this, temperature and/or other engine parameter measurements may be made downstream of the turbine, in a lower temperature environment. The downstream temperature and/or other engine parameter measurement values may be utilized in engine control systems and in visual displays to engine operators to ensure safe engine operation. Because the downstream temperature and/or other engine parameter measurement values do not reflect actual turbine temperature and/or other engine parameter measurement values, an accurate translation is desired to correlate measured temperature or other parameter values to actual values.

Hence, it is desirable to provide systems and methods for accurately correlating measured turbine engine parameter values to actual turbine engine parameter values. Furthermore, other desirable features and characteristics of the present disclosure will become apparent from the subsequent detailed description and the appended claims, taken in conjunction with the accompanying drawings and the foregoing technical field and background.

### SUMMARY

This summary is provided to describe select concepts in a simplified form that are further described in the Detailed Description. This summary is not intended to identify key or essential features of the claimed subject matter, nor is it intended to be used as an aid in determining the scope of the claimed subject matter.

In some aspects, the techniques described herein relate to a method including: generating a plurality of three-dimensional (3-D) thermodynamic surface maps for a plurality of stations of a gas turbine engine based on a thermodynamic engine model for the gas turbine engine, each of the plurality of thermodynamic surface maps having a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter; capturing, during flight using aircraft sensors, a plurality of measurable thermodynamic engine parameters; reading an estimated parameter value for the third thermodynamic engine parameter from each of the plurality of thermodynamic surface maps based on selected values for the first thermodynamic engine parameter and the second thermodynamic engine parameter; estimating an unmeasured temperature value based on the estimated parameter values read from the plurality of thermodynamic surface maps; and controlling the gas turbine engine during a mission based on the estimated unmeasured temperature value.

In some aspects, the techniques described herein relate to an aerial vehicle, including: a turbine engine; and a turbine engine control system including a controller configured to: receive, during flight, a plurality of measurable thermodynamic engine parameters captured using aerial vehicle sensors; read an estimated parameter value from each of a plurality of thermodynamic surface maps, wherein the plurality of thermodynamic surface maps have a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter, wherein the estimated parameter values are read from the third thermodynamic engine parameter from each of a plurality of thermodynamic surface maps based on selected values for a first thermodynamic engine parameter and a second thermodynamic engine parameter; estimate an unmeasured temperature value based on the estimated parameter values read from the plurality of thermodynamic surface maps; and control the turbine engine during a mission based on the estimated unmeasured temperature value.

In some aspects, the techniques described herein relate to a method in an aircraft including: receiving, during flight, a plurality of measurable thermodynamic engine parameters captured using aerial vehicle sensors; reading an estimated parameter value from each of a plurality of thermodynamic surface maps, wherein the plurality of thermodynamic surface maps have a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter, wherein the estimated parameter values are read from the third thermodynamic engine parameter from each of a plurality of thermodynamic surface maps based on selected values for a first thermodynamic engine parameter and a second thermodynamic engine parameter; estimating an unmeasured temperature value based on the estimated parameter values read from the plurality of thermodynamic surface maps; and controlling a turbine engine in the aircraft during a mission based on the estimated unmeasured temperature value.

Furthermore, other desirable features and characteristics will become apparent from the subsequent detailed description and the appended claims, taken in conjunction with the accompanying drawings and the preceding background.

### BRIEF DESCRIPTION OF THE DRAWINGS

The present disclosure will hereinafter be described in conjunction with the following drawing figures, wherein like numerals denote like elements, and wherein:
FIG. 1 is a schematic diagram of an example gas turbine engine, in accordance with some embodiments;
FIG. 2 is a schematic diagram of an example gas turbine engine that includes two turbine sections, in accordance with some embodiments;
FIG. 3 is a process flow chart depicting an example process for calculating parameter values at hard to measure engine locations using engine parameters measured at easier to measure engine locations, in accordance with some embodiments;
FIG. 4 is a process flow chart depicting an example process for estimating an unmeasured temperature, in accordance with some embodiments;
FIGS. 5A-5H are diagrams illustrating example thermodynamic surface maps describing various thermodynamic relationships between various gas turbine engine stations, in accordance with some embodiments;
FIG. 6 is a process flow chart depicting an example process for estimating an unmeasured temperature, in accordance with some embodiments; and
FIG. 7 is a block diagram depicting an example unmeasured parameter display system in an aircraft, in accordance with some embodiments.

### DETAILED DESCRIPTION

The following detailed description is merely exemplary in nature and is not intended to limit the application and uses. Furthermore, there is no intention to be bound by any expressed or implied theory presented in the preceding technical field, background, summary, or the following detailed description. As used herein, the term "module" refers to any hardware, software, firmware, electronic control component, processing logic, and/or processor device, individually or in any combination, including without limitation: application specific integrated circuit (ASIC), a field-programmable gate-array (FPGA), an electronic circuit, a processor (shared, dedicated, or group) and memory that executes one or more software or firmware programs, a combinational logic circuit, and/or other suitable components that provide the described functionality.

Embodiments of the present disclosure may be described herein in terms of functional and/or logical block components and various processing steps. It should be appreciated that such block components may be realized by any number of hardware, software, and/or firmware components configured to perform the specified functions. For example, an embodiment of the present disclosure may employ various integrated circuit components, e.g., memory elements, digital signal processing elements, logic elements, look-up tables, or the like, which may carry out a variety of functions under the control of one or more microprocessors or other control devices. In addition, those skilled in the art will appreciate that embodiments of the present disclosure may be practiced in conjunction with any number of systems, and that the systems described herein is merely exemplary embodiments of the present disclosure.

For the sake of brevity, conventional techniques related to signal processing, data transmission, signaling, control, database systems, and other functional aspects of the systems (and the individual operating components of the systems) may not be described in detail herein. Furthermore, the connecting lines shown in the various figures contained herein are intended to represent example functional relationships and/or physical couplings between the various elements. It should be noted that many alternative or additional functional relationships or physical connections may be present in an embodiment of the present disclosure.

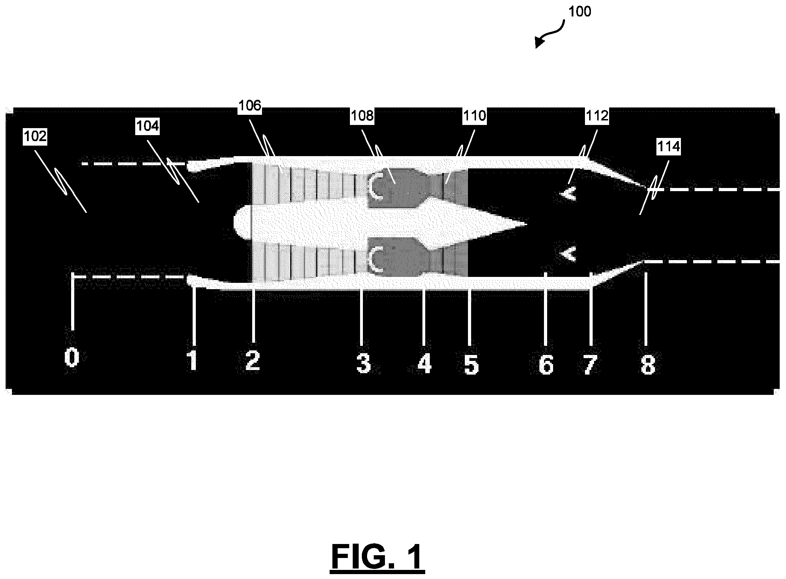

Gas turbine engines are used to power modern passenger and military aircraft (e.g., aerial vehicles such as an airplane or helicopter). Gas turbine engines come in a variety of shapes and sizes but have certain parts in common. FIG. 1 is a schematic diagram of an example gas turbine engine 100 that illustrates various components that are common to many gas turbine engines. Depicted on the schematic diagram of the example gas turbine engine 100 are a free stream location 102, an inlet 104, a compressor 106, a burner (or compressor 108), a turbine 110, an afterburner 112, and a nozzle 114.

As is customary for propulsion engineers, locations on the engine schematic of FIG. 1 are assigned station numbers. Free stream location (102) conditions are labeled 0 and the entrance to the inlet 104 is station 1. The exit of the inlet 104, which is the beginning of the compressor 106, is labeled station 2. The compressor (106) exit and burner (108) entrance is station 3 while the burner (108) exit and turbine (110) entrance is station 4. The exit of the turbine 110 is station 5 and the flow conditions upstream of the afterburner 112 occur at station 6. Station 7 is at the entrance to the nozzle 114 and station 8 is at the nozzle (114) throat.

Gas turbine engines can operate with two turbine sections, often referred to as the high-pressure turbine and low-pressure turbine or gas generator turbine and power turbine depending on the application. Two common locations for temperature measurement are at the low-pressure turbine (or power turbine) inlet or downstream of both turbine sections. Several factors drive the engine manufacturer's decision of which location to sample temperature. Measurement in the exhaust (downstream of both turbine sections) typical enables greater accessibility for maintenance/replacement and places the measurement system in a less harsh environment but may increase the uncertainty of the high-pressure (or gas generator) turbine inlet temperature calculation. Measurement at the low-pressure turbine (or power turbine) inlet can often have a linear temperature ratio relation to the turbine inlet temperature due to choked turbine nozzle flow designs but may require more robust measurement systems as they are subjected to higher temperatures and accessibility may be reduced for compact engine designs with overhanging reverse flow annular combustor designs.

When temperature is measured downstream of both turbine sections, the calculation of inter turbine temperature (often referred to in industry standard nomenclature as T45) can be challenging. In aircraft/rotorcraft engine applications, the calculation must be accurate at all operational conditions, including Altitude/Flight Mach/Temperature envelopes. The calculation must utilize only engine and aircraft measurements, which are far less than what is available in an engine test cell. The calculation must be robust to engine-to-engine variation and engine deterioration. Inaccuracies and uncertainty can lead to engines in the field being pulled for maintenance early, engines running in the field higher/longer than intended for the given life analysis or impose the requirement to run certain endurance and qualification testing higher than the field limit. In today's market, such consequences of calculation inaccuracies can be highly detrimental to new engine proposal competitiveness and reputation.

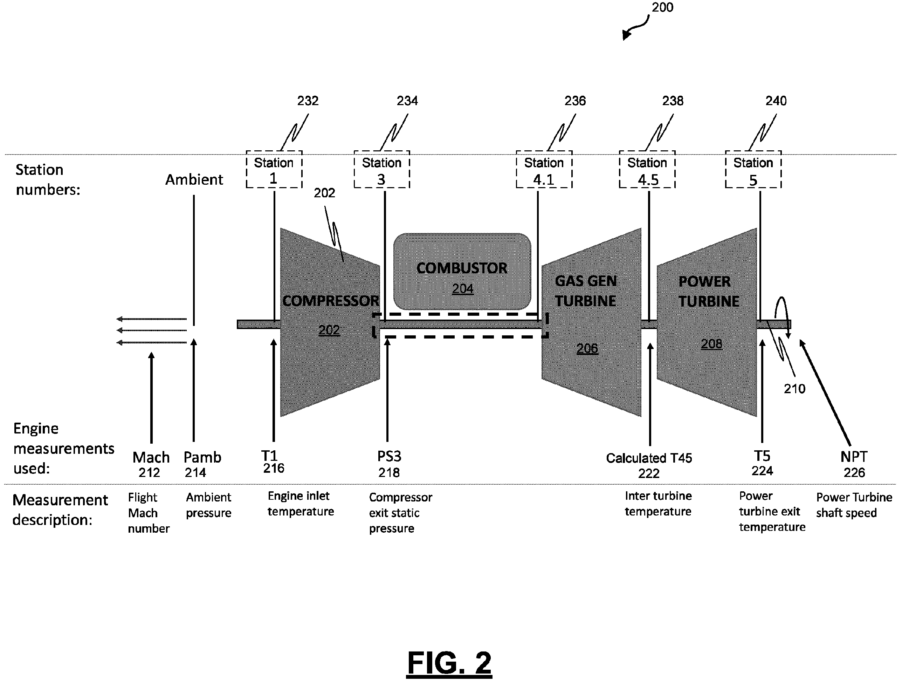

FIG. 2 is a schematic diagram of an example gas turbine engine 200 that includes two turbine sections, referred to as a high-pressure turbine and a low-pressure turbine in some applications or as a gas generator turbine and a power turbine in other applications. Depicted are a compressor 202, a combustor 204, a gas generator turbine 206, a power turbine 208, and a power turbine shaft 210.

The example schematic diagram also illustrates example engine parameters and station numbers corresponding to various engine parameters with regard to the example gas turbine engine 200. The illustrated engine parameters include a flight Mach number (Mach) 212, an ambient pressure (P_{amb}) 214, an engine inlet temperature (T1) 216, a compressor exit static pressure (PS3) 218, , an inter turbine temperature (T45) 222, a power turbine exit temperature (T5) 224, and a power turbine shaft speed (NPT) 226. The illustrated station numbers include an entrance to the inlet (station 1) 232, a compressor exit and burner entrance (station 3) 234, a gas generator turbine entrance (station 4.1) 236, an exit of the gas generator turbine and inlet to the power turbine (station 4.5) (also referred to herein as an inter turbine station) 238, and an exit of the power turbine (station 5) 240.

Many engine designers aim to limit temperature values at station 4.5 (238). Parameter values, such as temperature values, at station 4.5 (238) for a turbine environment operating at high temperature can exceed the temperature for which typical measurement devices could monitor. Because the turbine environment operating at high temperature often exceeds the temperature for which typical measurement devices can monitor, temperature is typically measured downstream of the turbine, in a lower temperature environment. To allow engine control systems and/or engine operators to account for and/or monitor temperature values at high temperature locations, such as at station 4.5 (238), to ensure safe engine operation, the subject matter described herein discloses apparatus, systems, methods, and techniques for calculating parameter values at hard to measure engine locations. In various embodiments, the subject matter described herein discloses apparatus, systems, methods, and techniques for calculating temperature values at high temperature locations, such as at station 4.5 (238) of a gas turbine engine. In various embodiments, the subject matter described herein discloses apparatus, systems, methods, and techniques for calculating temperature values at station 4.5 (238) of a gas turbine engine using engine parameters measured in a lower temperature environment.

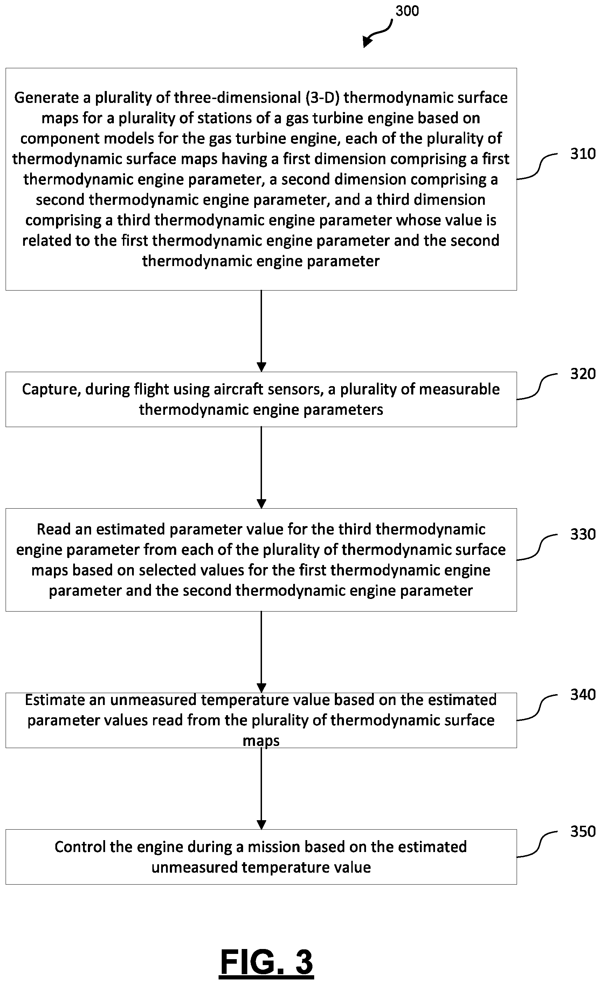

FIG. 3 is a process flow chart depicting an example process 300 for calculating parameter values at hard to measure engine locations using engine parameters measured at easier to measure engine locations. FIG. 3 is described in conjunction with FIG.2. The process 300 is merely an example and is not intended to limit the present disclosure beyond what is explicitly recited in the claims. The order of operation within the process 300 is not limited to the sequential execution as illustrated in the figure, but may be performed in one or more varying orders as applicable and in accordance with the present disclosure. Additional blocks may be provided before, during, and after process 300, and some of the blocks described can be moved, replaced, or eliminated for additional embodiments of process 300. Additional features may be added in the gas turbine engine 200 depicted in the figures, and some of the features described below can be replaced, modified, or eliminated in other embodiments.

At block 310, process 300 includes generating a plurality of three-dimensional (3-D) thermodynamic surface maps for a plurality of stations of a gas turbine engine. In various embodiments, the plurality of thermodynamic surface maps are derived from a thermodynamic engine model for the gas turbine engine. In various embodiments, the plurality of surface maps are generated before flight. In other embodiments, the plurality of surface maps may be generated during flight. In various embodiments, the thermodynamic surface maps are three-dimensional diagrams that describe a relationship of a first thermodynamic engine parameter in a first dimension and a second thermodynamic engine parameter in a second dimension to a third thermodynamic engine parameter in a third dimension. In use, a value for the third thermodynamic engine parameter can be read, for example by linear interpolation, from a thermodynamic surface map to provide an estimated thermodynamic engine parameter. In various embodiments, the third thermodynamic engine parameter can be read based on selected values for the first thermodynamic engine parameter and the second thermodynamic engine parameter. In various embodiments, a thermodynamic engine parameter includes a temperature value, a pressure value, a pressure ratio, a speed value, a specific heat ratio, a temperature difference over temperature ratio, or a temperature prediction error.

In various embodiments, three or more different types of thermodynamic surface maps are generated. In various embodiments, the three or more different types of thermodynamic surface maps include a first-type surface map, a second-type surface map, and a third-type surface map. In various embodiments, a first-type of surface map is a thermodynamic surface map wherein both the first thermodynamic engine parameter corresponds to a measurable thermodynamic engine parameter and the second thermodynamic engine parameter corresponds to a measurable thermodynamic engine parameter. In various embodiments, a measurable thermodynamic engine parameter is a thermodynamic engine parameter that can be measured during flight using aircraft sensors (onboard or offboard aircraft sensors).

In various embodiments, a second-type surface map is a thermodynamic surface map wherein one of the first thermodynamic engine parameter and the second thermodynamic engine parameter corresponds to a formula-derived thermodynamic engine parameter and the other of the first thermodynamic engine parameter and the second thermodynamic engine parameter corresponds to a measurable thermodynamic engine parameter. In various embodiments, a formula-derived thermodynamic engine parameter comprises a thermodynamic engine parameter that is derived from a predetermined mathematical relationship between one or more measurable thermodynamic engine parameters and/or one or more estimated thermodynamic engine parameters.

In various embodiments, a third-type surface map is a thermodynamic surface map wherein both the first thermodynamic engine parameter and the second thermodynamic engine parameter correspond to a formula-derived thermodynamic engine parameter or an estimated thermodynamic engine parameter.

In various embodiments, generating a plurality of thermodynamic surface maps includes generating one or more first-type surface maps, one or more second-type surface maps, and one or more third-type surface maps. In various embodiments, several thermodynamic surface maps are generated that include one or more first-type surface maps, one or more second-type surface maps, and one or more third-type surface maps. In an example implementation of process 300 to calculate a T45 temperature value, eight different thermodynamic surface maps are generated. In various embodiments, the number of thermodynamic surface maps that are generated correspond to the number needed, along with known mathematical relationships between thermodynamic engine parameters, to calculate an unmeasurable or unmeasured engine parameter.

At block 320, the process 300 includes capturing, during flight using aircraft sensors, a plurality of measurable thermodynamic engine parameters, and at block 330, the process 300 includes reading an estimated parameter value for the third thermodynamic engine parameter from each of the plurality of thermodynamic surface maps based on selected values for the first thermodynamic engine parameter and the second thermodynamic engine parameter.

In various embodiments, reading a value from each of the plurality of thermodynamic surface maps for the third thermodynamic engine parameter includes reading the first-type surface maps before reading the second-type and third-type surface maps. In various embodiments, the first-type surface maps may be read in any order or in parallel. In various embodiments, the second-type surface maps and third-type surface maps are read after any estimated thermodynamic engine parameter on which selected values for the first thermodynamic engine parameter and the second thermodynamic engine parameter for the surface map is based has been determined. In various embodiments, determining selected values for the first thermodynamic engine parameter and/or the second thermodynamic engine parameter includes performing one or more predetermined mathematical formulas involving a plurality of measured engine parameters and/or estimated engine parameters.

In various embodiments, reading a value from each of the plurality of thermodynamic surface maps for the third thermodynamic engine parameter includes reading a value from each of the plurality of thermodynamic surface maps for the third thermodynamic engine parameter in a single pass (i.e., reading each 3-D surface map at most once per temperature calculation cycle) with each of the plurality of thermodynamic surface maps. In various embodiments, reading a value involves using linear interpolation to estimate a value based on selected values for the first thermodynamic engine parameter and the second thermodynamic engine parameter that have been measured or calculated.

At block 340, the process 300 includes estimating an unmeasured temperature value based on the estimated engine parameters read from the plurality of thermodynamic surface maps. In various embodiments, the unmeasured temperature value is estimated based on an estimated temperature value for the third thermodynamic engine parameter from a surface map from the plurality of thermodynamic surface maps. In various embodiments, the surface map from the plurality of thermodynamic surface maps from which the estimated temperature value is read is the last surface map that is read. In various embodiments, further mathematical formulas are performed on the estimated temperature value for the third thermodynamic engine parameter from the surface map from the plurality of thermodynamic surface maps on which the unmeasured temperature value is based.

In various embodiments, estimating an unmeasured temperature value includes calculating several different formula-derived thermodynamic engine parameters. In an example implementation of process 300 to calculate a T45 temperature, estimating an unmeasured temperature value includes calculating at least seven different formula-derived thermodynamic engine parameters.

At block 350, the process 300 includes controlling the engine during a mission based on the estimated unmeasured temperature. In various embodiments, the engine is controlled to prevent the estimated unmeasured temperature from exceeding a threshold temperature level. In various embodiments, controlling the engine during a mission involves displaying the estimate unmeasured temperature so that an engine operator can adjust engine operations based on the estimated unmeasured temperature. In various embodiments, controlling the engine during a mission based on the estimated unmeasured temperature involves performing maintenance on the engine before the mission begins based on a history of the estimated unmeasured temperature.

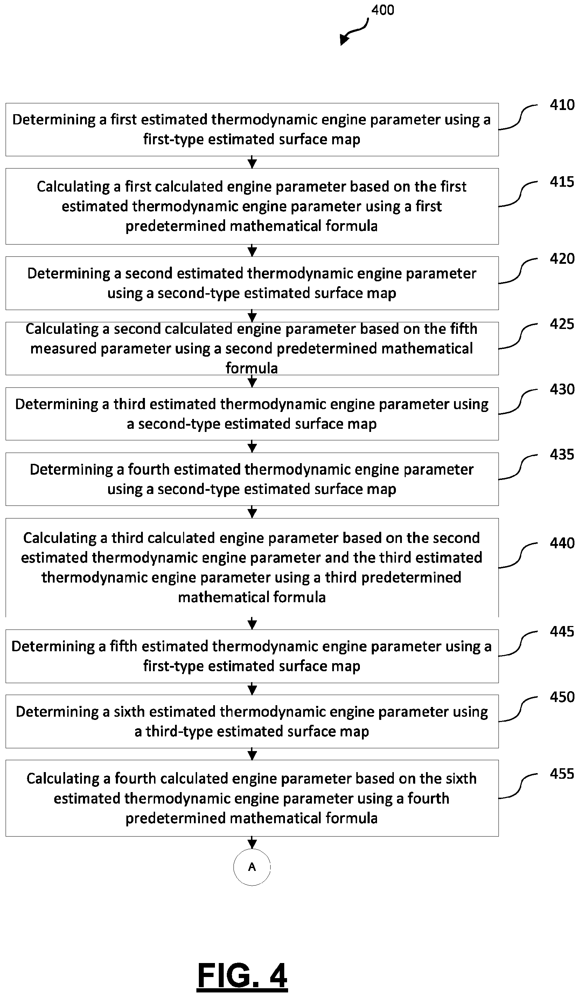

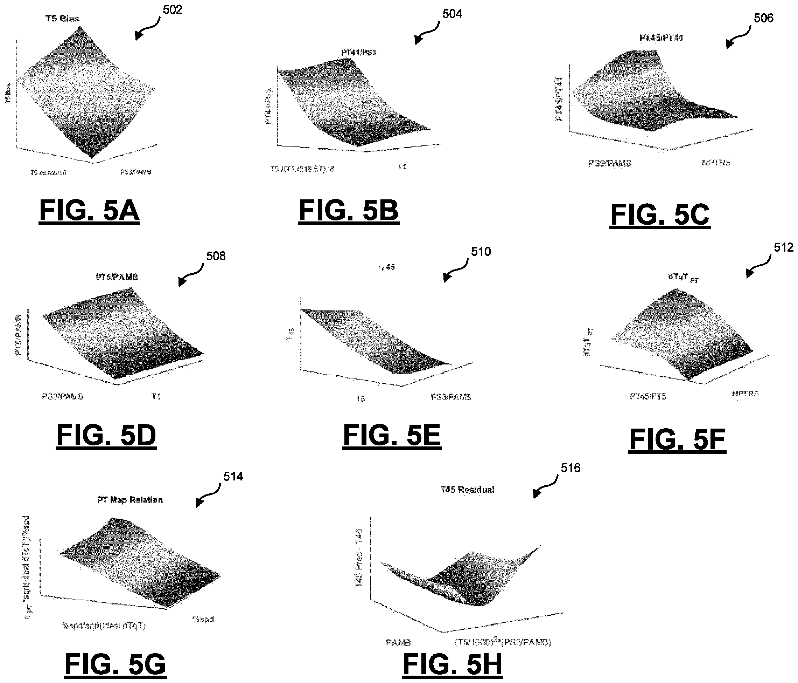

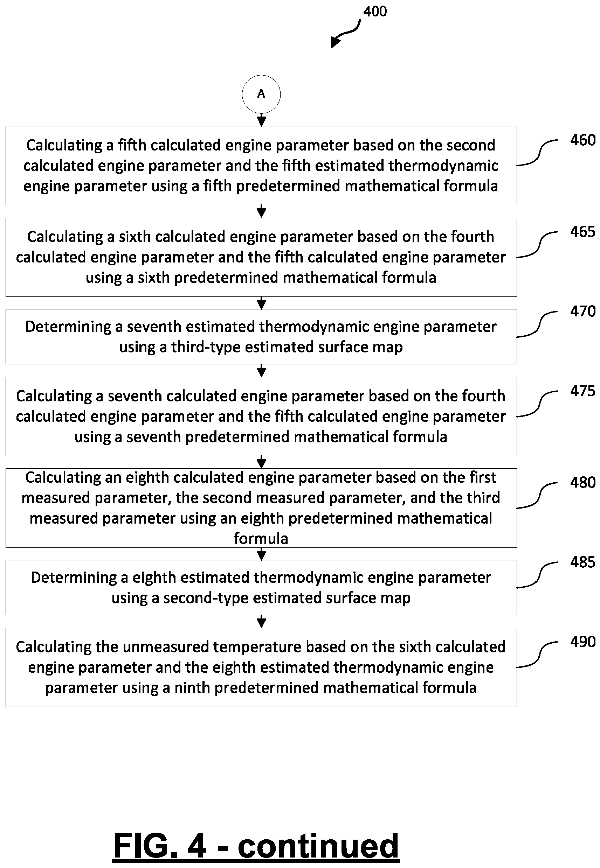

FIG. 4 is a process flow chart depicting an example process 400 for estimating an unmeasured temperature. FIG. 4 is described in conjunction with FIG.2 and with FIGS. 5A-5H, which illustrates example thermodynamic surface maps describing various thermodynamic relationships between various gas turbine engine stations, in accordance with some embodiments. The process 400 is merely an example and is not intended to limit the present disclosure beyond what is explicitly recited in the claims. The order of operation within the process 400 is not limited to the sequential execution as illustrated in the figure, but may be performed in one or more varying orders as applicable and in accordance with the present disclosure. Additional blocks may be provided before, during, and after process 400, and some of the blocks described can be moved, replaced, or eliminated for additional embodiments of process 400. Additional features may be added in the gas turbine engine 200 depicted in the figures, and some of the features described below can be replaced, modified, or eliminated in other embodiments.

**Table 1, shown below is presented to describe various Acronyms used in the discussion of process 400.**

| Acronym / Thermodynamic term | Description |
|---|---|
| T1 | engine inlet temperature |
| T45 | inter turbine temperature |
| T5 | power turbine exit temperature |
| P_{amb} | ambient pressure |
| PS3 | compressor exit static pressure |
| P41 | gas generator turbine inlet pressure |
| P45 | power turbine inlet pressure |
| P5 | power turbine exit pressure |
| Mach | flight Mach number |
| NPT | power turbine shaft speed |
| NPTR5 | power turbine shaft speed referred using T5 |
| NPTR% | power turbine shaft speed referred using T45, represented as a percentage of 100% speed |
| T5_{bias} | accounting for difference between the T5 from the measurement system and the actual thermodynamic T5 (using engine model) |
| Gamma45 | ratio of specific heat at constant pressure to specific heat at constant volume at station 4.5 |
| PT_dT/T | power turbine delta temperature over inlet temperature ((T45-T5)/T45) |
| Ideal PT_dT/T | power turbine isentropic temperature drop over inlet temperature ((T45-T5_ideal)/T45) |
| T45 residual | residual T45 prediction error used to dial in calculated T45 at the end of the algorithm |

At block 410, the example process 400 includes determining a first estimated thermodynamic engine parameter using a first-type estimated surface map. In an example implementation of block 410, the first estimated thermodynamic engine parameter (T5_{bias}) accounts for a difference between the power turbine exit temperature from the measurement system (T5_{measured}) and the actual power turbine exit temperature (TSactual) using the engine model, and FIG. 5A provides an example 3-D thermodynamic surface map 502 that can provide the first estimated thermodynamic engine parameter (TSbias) based on a first measured parameter (T5_{measured}), a second measured parameter (compressor exit static pressure (PS3)), and a third measured parameter (ambient pressure (P_{amb})).

At block 415, the example process 400 includes calculating a first calculated engine parameter based on the first estimated thermodynamic engine parameter. In an example implementation of block 415, the first calculated engine parameter (T5_ref) is calculated based on a first predetermined mathematical formula, wherein T5_ref = T5 / (T1 / 518.67) ^(0.8).

At block 420, the example process 400 includes determining a second estimated thermodynamic engine parameter using a second-type estimated surface map. In an example implementation of block 420, the second estimated thermodynamic engine parameter (P41/PS3) is a ratio of the gas generator turbine inlet pressure (P41) over the compressor exit static pressure (PS3), and FIG. 5B provides an example 3-D thermodynamic surface map 504 that can provide the second estimated thermodynamic engine parameter (P41/PS3) based on the first calculated engine parameter (T5_ref) and a fourth measured parameter (engine inlet temperature (T1)).

At block 425, the example process 400 includes calculating a second calculated engine parameter based on the fifth measured parameter. In an example implementation of block 425, the second calculated engine parameter (NPTRS) is calculated based on a second predetermined mathematical formula, wherein NPTR5 = NPT / SQRT (T5 / 518.67) and NPT (power turbine shaft speed) is a fifth measured parameter.

At block 430, the example process 400 includes determining a third estimated thermodynamic engine parameter using a second-type estimated surface map. In an example implementation of block 430, the third estimated thermodynamic engine parameter (P45/P41) is a ratio of the power turbine inlet pressure (P45) over the gas generator turbine inlet pressure (P41), and FIG. 5C provides an example 3-D thermodynamic surface map 506 that can provide the third estimated thermodynamic engine parameter (P45/P41) based on , the second measured parameter (compressor exit static pressure (PS3)), the third measured parameter (ambient pressure (P_{amb})), and the second calculated parameter (NPTR5).

At block 435, the example process 400 includes determining a fourth estimated thermodynamic engine parameter using a second-type estimated surface map. In an example implementation of block 435, the fourth estimated thermodynamic engine parameter (P45/P_{amb}) is a ratio of the power turbine exit pressure (P45) over the ambient pressure (P_{amb}), and FIG. 5D provides an example 3-D thermodynamic surface map 508 that can provide the fourth estimated thermodynamic engine parameter (P45/Pamb) based on the second measured parameter (compressor exit static pressure (PS3)), the third measured parameter (ambient pressure (P_{amb})), and the fourth measured parameter (engine inlet temperature (T1)).

At block 440, the example process 400 includes calculating a third calculated engine parameter based on the second estimated thermodynamic engine parameter and the third estimated thermodynamic engine parameter. In an example implementation of block 440, the third calculated engine parameter (P45/P5) is calculated based on a third predetermined mathematical formula, wherein P45/P5 = PS3 * P41/PS3 * P45/P41 * (1 / P5/P_{amb}) * (1/P_{amb}).

At block 445, the example process 400 includes determining a fifth estimated thermodynamic engine parameter using a first-type estimated surface map. In an example implementation of block 445, the fifth estimated thermodynamic engine parameter (Gamma45) is a ratio of specific heat at constant pressure to specific heat at constant volume at station 4.5, and FIG. 5E provides an example 3-D thermodynamic surface map 510 that can provide the fifth estimated thermodynamic engine parameter (Gamma45) based on the first measured parameter (T5measured), the second measured parameter (compressor exit static pressure (PS3)), and the third measured parameter (ambient pressure (P_{amb})).

At block 450, the example process 400 includes determining a sixth estimated thermodynamic engine parameter using a third-type estimated surface map. In an example implementation of block 450, the sixth estimated thermodynamic engine parameter (PT_dT/T) is a power turbine delta temperature (T45-T5) over power turbine inlet temperature (T45) ratio, and FIG. 5F provides an example 3-D thermodynamic surface map 512 that can provide the sixth estimated thermodynamic engine parameter (PT_dT/T) based on the third calculated engine parameter (P45/P5) and the second calculated engine parameter (NPTRS).

At block 455, the example process 400 includes calculating a fourth calculated engine parameter based on the sixth estimated thermodynamic engine parameter. In an example implementation of block 455, the fourth calculated engine parameter (NPTR%) is calculated based on a fourth predetermined mathematical formula, wherein NPTR% = (1 / 76.37) * NPT / SQRT ( ( dT/T * T5 + T5) / 518.67).

At block 460, the example process 400 includes calculating a fifth calculated engine parameter based on the second calculated engine parameter and the fifth estimated thermodynamic engine parameter. In an example implementation of block 460, the fifth calculated engine parameter (ideal PT_dT/T) is calculated based on a fifth predetermined mathematical formula, wherein ideal PT_dT/T = 1- (1 / P45/P5) ^ (Gamma45 - 1) / Gamma45).

At block 465, the example process 400 includes calculating a sixth calculated engine parameter based on the fourth calculated engine parameter and the fifth calculated engine parameter. In an example implementation of block 465, the sixth calculated engine parameter (NPTR%Q) is calculated based on a sixth predetermined mathematical formula, wherein NPTR%Q = NPTR% / SQRT (ideal PT_dT/T).

At block 470, the example process 400 includes determining a seventh estimated thermodynamic engine parameter using a third-type estimated surface map. In an example implementation of block 470, the seventh estimated thermodynamic engine parameter (PT efficiency map relation) is a power turbine efficiency map relation, and FIG. 5G provides an example 3-D thermodynamic surface map 514 that can provide the seventh estimated thermodynamic engine parameter (PT efficiency map relation) based on the sixth calculated engine parameter (NPTR%Q) and the fourth calculated engine parameter (NPTR%).

At block 475, the example process 400 includes calculating a seventh calculated engine parameter based on the fourth calculated engine parameter and the fifth calculated engine parameter. In an example implementation of block 475, the seventh calculated engine parameter (PT_{eff}) is calculated based on a seventh predetermined mathematical formula, wherein PT_{eff} = PT efficiency map relation * NPTR% / SQRT (ideal PT_dT/T)

At block 480, the example process 400 includes calculating an eighth calculated engine parameter based on the first measured parameter, the second measured parameter, and the third measured parameter. In an example implementation of block 480, the eighth calculated engine parameter (T5_term) is calculated based on an eighth predetermined mathematical formula, wherein T5_term = (T5 /1000) ^2 * PS3/P_{amb}.

At block 485, the example process 400 includes determining an eighth estimated thermodynamic engine parameter using a second-type estimated surface map. In an example implementation of block 485, the eighth estimated thermodynamic engine parameter (T45_{residial}) is an inter turbine temperature prediction error, and FIG. 5H provides an example 3-D thermodynamic surface map 516 that can provide the eighth estimated thermodynamic engine parameter (T45_{residial}) based on the third measured parameter (ambient pressure (P_{amb})) and the eighth calculated engine parameter (T5_term).

At block 490, the example process 400 includes calculating the unmeasured temperature based on the third calculated engine parameter (P45/P5), the fifth estimated thermodynamic engine parameter (Gamma45), first measured parameter (T5_{measured}), and the eighth estimated thermodynamic engine parameter (T45_{residial}). In an example implementation of block 490, the unmeasured temperature (T45F) is calculated based on a ninth predetermined mathematical formula, wherein T45F = T45 - 459.67; T45 = T5 / Tempratio_T5/T45; and Tempratio_T5/T45 = (1 / P45/P5) ^ (PT_{eff} * (Gamma45 -1) / Gamma45).

In various embodiments, the first measured parameter is a power turbine exit temperature (T5); the second measured parameter is a compressor exit static pressure (PS3); the third measured parameter is an ambient pressure (P_{amb}); the fourth measured parameter is an engine inlet temperature (T1); the fifth measured parameter is a power turbine shaft speed (NPT); the sixth measured parameter is a flight Mach number (Mach); and the unmeasured temperature is an inter turbine temperature (T45).

In various embodiments, the first estimated thermodynamic engine parameter (TSbias) accounts for a difference between the power turbine exit temperature from the measurement system (T5_{measured}) and the actual power turbine exit temperature (TSactual) using the engine model; the second estimated thermodynamic engine parameter (P41/PS3) is a ratio of the gas generator turbine inlet pressure (P41) over the compressor exit static pressure (PS3); the third estimated thermodynamic engine parameter (P45/P41) is a ratio of the power turbine inlet pressure (P45) over the gas generator turbine inlet pressure (P41); the fourth estimated thermodynamic engine parameter (P45/P_{amb}) is a ratio of the power turbine exit pressure (P45) over the ambient pressure (P_{amb}); the fifth estimated thermodynamic engine parameter (Gamma45) is a ratio of specific heat at constant pressure to specific heat at constant volume at station 4.5; the sixth estimated thermodynamic engine parameter (PT_dT/T) is a power turbine delta temperature (T45-T5) over power turbine inlet temperature (T45) ratio; the seventh estimated thermodynamic engine parameter (PT efficiency map relation) is a power turbine efficiency map relation; and the eighth estimated thermodynamic engine parameter (T45_{residial}) is an inter turbine temperature prediction error.

In various embodiments, the first calculated engine parameter (T5_ref) is a modified power turbine exit temperature; the second calculated engine parameter (NPTRS) is a shaft speed referred using T5; the third calculated engine parameter (P45/P5) is a ratio of power turbine inlet pressure (P45) over power turbine exit pressure (P5); the fourth calculated engine parameter (NPTR%) is a power turbine shaft speed referred using T45 that is represented as a percentage of 100% speed; the fifth calculated engine parameter

(ideal PT_dT/T)) is an ideal power turbine delta temperature over inlet temperature ((T45-T5_ideal)/T45); the sixth calculated engine parameter is NPTR%Q; the seventh calculated engine parameter (PT_{eff}) is a measure of power turbine efficiency; and the eighth calculated engine parameter is T5_term.

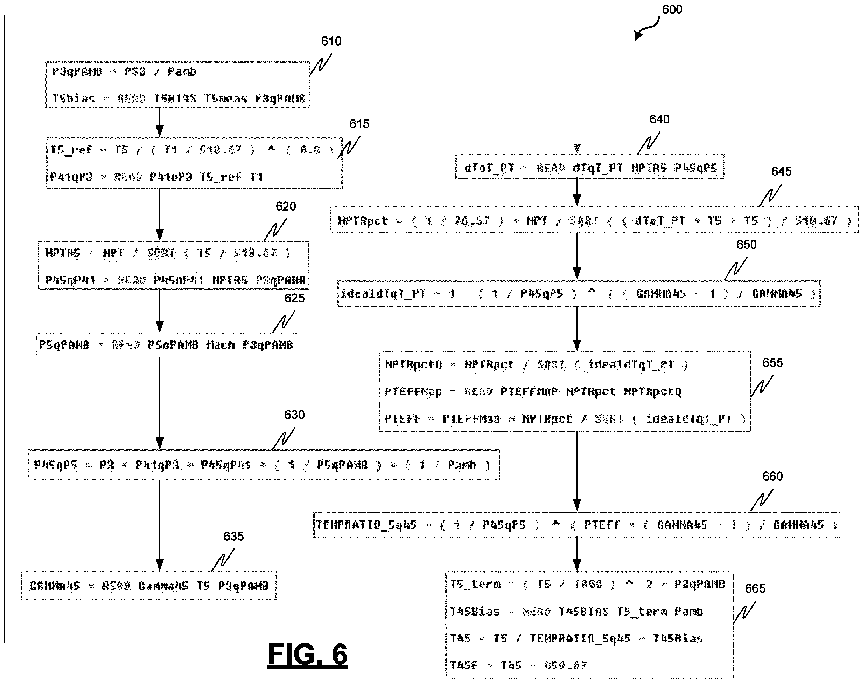

FIG. 6 is a process flow chart depicting another example process 600 for estimating an unmeasured temperature. FIG. 6 is described in conjunction with FIG.2 and with FIGS. 5A-5H, which illustrates example thermodynamic surface maps describing various thermodynamic relationships between various gas turbine engine stations, in accordance with some embodiments. The process 600 is merely an example and is not intended to limit the present disclosure beyond what is explicitly recited in the claims. The order of operation within the process 600 is not limited to the sequential execution as illustrated in the figure, but may be performed in one or more varying orders as applicable and in accordance with the present disclosure. Additional blocks may be provided before, during, and after process 600, and some of the blocks described can be moved, replaced, or eliminated for additional embodiments of process 600. Additional features may be added in the gas turbine engine 200 depicted in the figures, and some of the features described below can be replaced, modified, or eliminated in other embodiments.

At block 610, the example process 600 includes evaluating PS3/P_{amb} = PS3 / P_{amb} and reading T5_{bias} from surface map 502 based on selected values (T5_{measured} and PS3/P_{amb}) for the first and second parameters of surface map 502.

At block 615, the example process 600 includes evaluating T5_ref = T5 / (T1 / 518.67) ^ (0.8) and reading P41/PS3 from surface map 504 based on selected values (T5_ref and T1) for the first and second parameters of surface map 504.

At block 620, the example process 600 includes evaluating NPTR5 = NPT / SQRT (T5 / 518.67) and reading P45/P41 from surface map 506 based on selected values (NPTRS and PS3/P_{amb}) for the first and second parameters of surface map 506.

At block 625, the example process 600 includes reading P5/P_{amb} from surface map 508 based on selected values (Mach and PS3/P_{amb}) for the first and second parameters of surface map 508.

At block 630, the example process 600 includes evaluating P45/P5 = PS3 * P41/PS3 * P45/P41 * (1/ P5/P_{amb}) * (1/P_{amb}).

At block 635, the example process 600 includes reading Gamma45 from surface map 510 based on selected values (T5_{measured} and PS3/P_{amb}) for the first and second parameters of surface map 510.

At block 640, the example process 600 includes reading PT_dT/T from surface map 512 based on selected values (NPTRS and P45/P5) for the first and second parameters of surface map 512.

At block 645, the example process 600 includes evaluating NPTR% = (1 / 76.37) * NPT / SQRT ( ( dT/T * T5 + T5) / 518.67).

At block 650, the example process 600 includes evaluating ideal PT_dT/T = 1 - (1 / P45/P5) ^ (Gamma45 - 1) / Gamma45).

At block 655, the example process 600 includes evaluating NPTR%Q = NPTR% / SQRT (ideal PT_dT/T), reading PT efficiency map relation from surface map 514 based on selected values (NPTR% and NPTR%Q) for the first and second parameters of surface map 514, and evaluating PT_{eff} = PT efficiency map relation * NPTR% / SQRT (ideal PT_dT/T).

At block 660, the example process 600 includes evaluating Tempratio_T5/T45 = (1 / P45/P5) ^ (PT_{eff} * (Gamma45 -1) / Gamma45).

At block 665, the example process 600 includes evaluating T5_term = (T5 /1000) ^2 * PS3/P_{amb} , reading T45_{Bias} from surface map 516 based on selected values (T5_term and P_{amb}) for the first and second parameters of surface map 516, evaluating T45 = T5 / Tempratio_T5/T45 - T45_{Bias}, and evaluating T45F = T45 - 459.67, wherein T45F is the unmeasured parameter to be estimated.

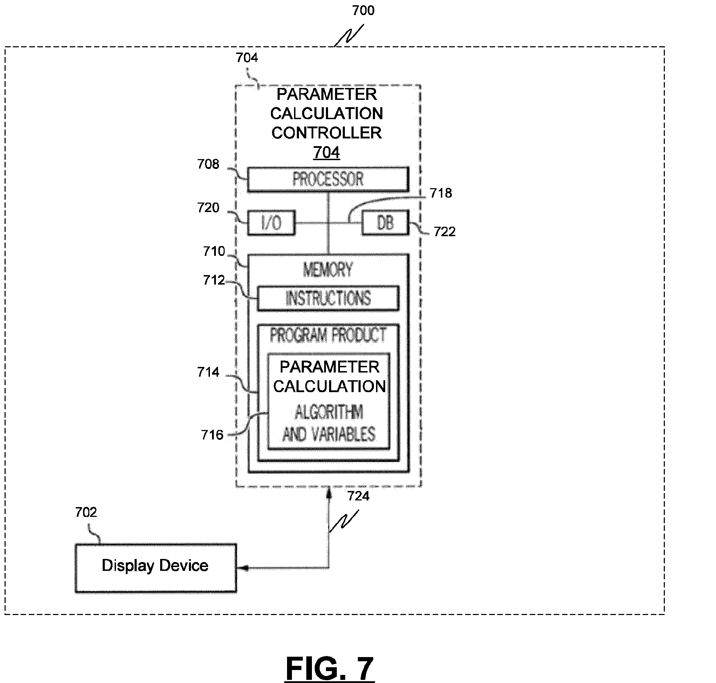

FIG. 7 is a block diagram depicting an example control system 700 in an aircraft that is capable of performing process 300, 400 and/or 600. The example control system 700 includes a display device 702 (such as a primary flight display (PFD) and/or other display) and a parameter calculation controller 704. In various embodiments, the display device 702 has at least one display unit and at least one user input mechanism. In various embodiments, the display device 702 includes a touchscreen device having at least one touchscreen display as a display unit and a touchscreen surface as a user input mechanism. In various embodiments, the display device 702 includes a mouse and/or keyboard as user input mechanisms. The example parameter calculation controller 704 may be incorporated in various avionics equipment (e.g., onboard avionics equipment such as a flight management system, offboard avionics equipment such as a portable electronic device such as a laptop computer, tablet computer, smartphone, electronic flight bag, or dedicated hardware)

The example parameter calculation controller 704 includes a processing component comprising at least one processor 708 and a computer-readable storage device or media (such as memory 710) encoded with programming instructions for configuring the processing component. The processor 708 may comprise any type of processor or multiple processors, any custom-made or commercially available processor, a central processing unit (CPU), a graphics processing unit (GPU), an application specific integrated circuit (ASIC), a field programmable gate array (FPGA), an auxiliary processor among several processors associated with the processing component, a semiconductor-based microprocessor (in the form of a microchip or chip set), any combination thereof, or generally any device for executing instructions to carry out the described operations, tasks, and functions by manipulating electrical signals representing data bits at memory locations in system memory, as well as other processing of signals.

The computer readable storage device or media (e.g., memory 710) may include volatile and nonvolatile storage in read-only memory (ROM), random-access memory (RAM), and keep-alive memory (KAM), for example. KAM is a persistent or non-volatile memory that may be used to store various operating variables while the processor is powered down. The computer-readable storage device or media may be implemented using any of a number of known memory devices such as PROMs (programmable read-only memory), EPROMs (electrically PROM), EEPROMs (electrically erasable PROM), flash memory, or any other electric, magnetic, optical, or combination memory devices capable of storing data, some of which represent executable programming instructions, used by the processing component. The memory 710 may be located on and/or co-located on the same computer chip as the processor 708. Generally, the memory 710 maintains data bits and may be utilized by the processor 708 as storage and/or a scratch pad during operation. Specifically, the memory 710 stores instructions and applications 712. Information in the memory 710 may be organized and/or imported from an external source during an initialization step of a process; it may also be programmed via a user input device (e.g., associated with the Display device 702). During operation, the processor 708 loads and executes one or more programs, algorithms and rules embodied as instructions and applications 712 contained within the memory 710 and, as such, controls the general operation of the parameter calculation controller 704.

The memory 710 includes a novel program 716 that includes rules and instructions that, when executed, convert the processing component (e.g., processor 708/memory 710) configuration into parameter calculation controller 704, which is a novel controller that performs the functions, techniques, and processing tasks associated with estimating an unmeasurable temperature using a plurality of 3-D thermodynamic surface maps, measured engine parameters, and a plurality of predetermine mathematic equations. The novel program 716 directs receiving a plurality of measurable thermodynamic engine parameters during flight from aircraft sensors, reading an estimated parameter value for the third thermodynamic engine parameter from each of a plurality of thermodynamic surface maps based on selected values for the first thermodynamic engine parameter and the second thermodynamic engine parameter, estimating an unmeasured temperature value based on the estimated parameter values read from the plurality of thermodynamic surface maps, and providing the estimated unmeasured temperature value so that an aircraft engine may be controlled and/or monitored during a mission. The novel program 716 and associated stored variables may be stored in a functional form on computer readable media, for example, as depicted, in memory 710. While the depicted exemplary embodiment of the parameter calculation controller is described in the context of a fully functioning computer system, those skilled in the art will recognize that the mechanisms of the present disclosure are capable of being distributed as a program product 714.

As a program product 714, one or more types of non-transitory computer-readable signal bearing media may be used to store and distribute the program 716, such as a non-transitory computer readable medium bearing the program 716 and containing therein additional computer instructions for causing a computer processor (such as the processor 708) to load and execute the program 716. Such a program product 714 may take a variety of forms, and the present disclosure applies equally regardless of the type of computer-readable signal bearing media used to carry out the distribution. Examples of signal bearing media include recordable media such as floppy disks, hard drives, memory cards and optical disks, and transmission media such as digital and analog communication links. It will be appreciated that cloud-based storage and/or other techniques may also be utilized as memory 710 in certain embodiments.

In various embodiments, the processing component (e.g., processor 708/memory 710) configuration of the parameter calculation controller 704 may be communicatively coupled (via a bus 718) to an input/output (I/O) interface 720, and a database 722. The bus 718 serves to transmit programs, data, status and other information or signals between the various components of the parameter calculation controller 704. The bus 718 can be any suitable physical or logical means of connecting computer systems and components. This includes, but is not limited to, direct hard-wired connections, fiber optics, infrared and wireless bus technologies.

The I/O interface 720 enables intra controller communication, as well as communications between the parameter calculation controller 704 and other system components (such as a display device 702) via the communication system and fabric 724 and between the parameter calculation controller 704 and external data sources via the communication system and fabric 724. The I/O interface 720 may include one or more network interfaces and can be implemented using any suitable method and apparatus. In various embodiments, the I/O interface 720 is configured to support communication from an external system driver and/or another computer system. In one embodiment, the I/O interface 720 is integrated with the communication system and fabric 724 and obtains data from external data source(s) directly. Also, in various embodiments, the I/O interface 720 may support communication with technicians, and/or one or more storage interfaces for direct connection to storage apparatuses, such as the database 722. In some embodiments, the database 722 is part of the memory 710. In various embodiments, the database 722 is integrated, either within the parameter calculation controller 704 or external to it.

In various embodiments, the example parameter calculation controller 704 is configured to generate a plurality of three-dimensional (3-D) thermodynamic surface maps for a plurality of stations of a gas turbine engine based on a thermodynamic engine model for the gas turbine engine, each of the plurality of thermodynamic surface maps having a first dimension comprising a first thermodynamic engine parameter, a second dimension comprising a second thermodynamic engine parameter, and a third dimension comprising a third thermodynamic engine parameter whose value is related to the first thermodynamic engine parameter and the second thermodynamic engine parameter. In various embodiments, the plurality of three-dimensional (3-D) thermodynamic surface maps are stored in the database 722.

The subject matter described herein provides apparatus, systems, methods, and techniques for improving turbine temperature synthesis for field usage from measured exhaust gas temperature by utilizing a methodology based on thermodynamics and component performance to accurately estimate temperature ratios across the turbines for the full range of flight envelopes. The accuracy and robustness of the methodology can enable flexibility in engine design decisions without compromise of product integrity.

The subject matter described herein discloses apparatus, systems, methods, and techniques wherein the recurring cost for implementation is essentially zero because additional sensors or measurements are not required for implementation either on the engine or the aircraft. The subject matter described herein discloses apparatus, systems, methods, and techniques improving the safety, reliability, and functionality of gas turbine engines.

In some aspects, the techniques described herein relate to a method including: generating a plurality of three-dimensional (3-D) thermodynamic surface maps for a plurality of stations of a gas turbine engine based on a thermodynamic engine model for the gas turbine engine, each of the plurality of thermodynamic surface maps having a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter; capturing, during flight using aircraft sensors, a plurality of measurable thermodynamic engine parameters; reading an estimated parameter value for the third thermodynamic engine parameter from each of the plurality of thermodynamic surface maps based on selected values for the first thermodynamic engine parameter and the second thermodynamic engine parameter; estimating an unmeasured temperature value based on the estimated parameter values read from the plurality of thermodynamic surface maps; and controlling the gas turbine engine during a mission based on the estimated unmeasured temperature value.

In some aspects, the techniques described herein relate to a method, wherein a thermodynamic engine parameter includes a temperature value, a pressure value, a pressure ratio, a speed value, a specific heat ratio, a temperature difference over temperature ratio, a temperature prediction error, or a turbine efficiency * sqrt (ideal delta T/T) / %spd factor.

In some aspects, the techniques described herein relate to a method, wherein the plurality of thermodynamic surface maps includes: one or more first-type surface maps wherein both the first thermodynamic engine parameter corresponds to a measurable thermodynamic engine parameter and the second thermodynamic engine parameter corresponds to a measurable thermodynamic engine parameter, wherein a measurable thermodynamic engine parameter includes a thermodynamic engine parameter that can be measured during flight using aircraft sensors; one or more second-type surface maps wherein one of the first thermodynamic engine parameter and the second thermodynamic engine parameter corresponds to a formula-derived thermodynamic engine parameter and a second of the first thermodynamic engine parameter and the second thermodynamic engine parameter corresponds to a measurable thermodynamic engine parameter, wherein a formula-derived thermodynamic engine parameter includes a thermodynamic engine parameter that is derived from a predetermined mathematical relationship between one or more measurable thermodynamic engine parameters and/or one or more estimated thermodynamic engine parameters; and one or more third-type surface maps, both the first thermodynamic engine parameter and the second thermodynamic engine parameter correspond to a formula-derived thermodynamic engine parameter or an estimated thermodynamic engine parameter.

In some aspects, the techniques described herein relate to a method, wherein reading the estimated parameter value includes reading a value from each of the plurality of thermodynamic surface maps for the third thermodynamic engine parameter in a single pass with each of the plurality of thermodynamic surface maps.

In some aspects, the techniques described herein relate to a method, wherein reading the estimated parameter value includes using linear interpolation to estimate a value based on selected values for the first thermodynamic engine parameter and the second thermodynamic engine parameter that have been measured or calculated.

In some aspects, the techniques described herein relate to a method, wherein the plurality of measurable thermodynamic engine parameters includes: a first measured parameter including a power turbine exit temperature (T5), a second measured parameter including a compressor exit static pressure (PS3), a third measured parameter including an ambient pressure (P_{amb}), a fourth measured parameter including an engine inlet temperature (T1), a fifth measured parameter including a power turbine shaft speed (NPT), and a sixth measured parameter including a flight Mach number (Mach).

In some aspects, the techniques described herein relate to a method, wherein generating a plurality of thermodynamic surface maps includes generating at least eight different thermodynamic surface maps.

In some aspects, the techniques described herein relate to a method, wherein reading the estimated parameter value for the third thermodynamic engine parameter from each of the plurality of thermodynamic surface maps includes reading: a TSbias from a first thermodynamic surface map, a P41/PS3 ratio from a second thermodynamic surface map, a P45/P41 ratio from a third thermodynamic surface map, a P45/P_{amb} ratio from a fourth thermodynamic surface map, a ratio of specific heat at constant pressure to specific heat at constant volume at station 4.5 (Gamma45) from a fifth thermodynamic surface map, a power turbine delta temperature (T45-T5) over power turbine inlet temperature (T45) ratio from a sixth thermodynamic surface map, a power turbine efficiency map relation from a seventh thermodynamic surface map, and an inter turbine temperature prediction error from an eight thermodynamic surface map.

In some aspects, the techniques described herein relate to a method, further including calculating at least eight different formula-derived thermodynamic engine parameters.

In some aspects, the techniques described herein relate to a method, wherein calculating at least eight different formula-derived thermodynamic engine parameters includes calculating: a modified power turbine exit temperature as a first calculated engine parameter; a shaft speed referred using T5 as a second calculated engine parameter (NPTRS); a ratio of power turbine inlet pressure (P45) over power turbine exit pressure (P5) as a third calculated engine parameter (P45/P5); a power turbine shaft speed referred using T45 that is represented as a percentage of 100% speed as a fourth calculated engine parameter (NPTR%); an ideal power turbine delta temperature over inlet temperature ((T45-T5_ideal)/T45) as a fifth calculated engine parameter (ideal PT_dT/T)); a sixth calculated engine parameter related to the fourth calculated engine parameter; a measure of power turbine efficiency as a seventh calculated engine parameter (PT_{eff}); and an eighth calculated engine parameter T5_term wherein T5_term = (T5 /1000) ^2 * PS3/P_{amb}.

In some aspects, the techniques described herein relate to a method, wherein estimating the unmeasured temperature value based on the estimated parameter values read from the plurality of thermodynamic surface maps includes calculating the unmeasured temperature based on the sixth calculated engine parameter and the inter turbine temperature prediction error using a ninth predetermined mathematical formula.

In some aspects, the techniques described herein relate to a method, wherein the ninth predetermined mathematical formula includes T45F = T45 - 459.67, wherein T45 = T5 / Tempratio_T5/T45, and Tempratio_T5/T45 = (1 / P45/P5) ^ (PT_{eff} * (Gamma45 -1) / Gamma45).

In some aspects, the techniques described herein relate to an aerial vehicle, including: a turbine engine; and a turbine engine control system including a controller configured to: receive, during flight, a plurality of measurable thermodynamic engine parameters captured using aerial vehicle sensors; read an estimated parameter value from each of a plurality of thermodynamic surface maps, wherein the plurality of thermodynamic surface maps have a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter, wherein the estimated parameter values are read from the third thermodynamic engine parameter from each of a plurality of thermodynamic surface maps based on selected values for a first thermodynamic engine parameter and a second thermodynamic engine parameter; estimate an unmeasured temperature value based on the estimated parameter values read from the plurality of thermodynamic surface maps; and control the turbine engine during a mission based on the estimated unmeasured temperature value.

In some aspects, the techniques described herein relate to an aerial vehicle, wherein the plurality of thermodynamic surface maps includes: one or more first-type surface maps wherein both the first thermodynamic engine parameter corresponds to a measurable thermodynamic engine parameter and the second thermodynamic engine parameter corresponds to a measurable thermodynamic engine parameter, wherein a measurable thermodynamic engine parameter includes a thermodynamic engine parameter that can be measured during flight using aircraft sensors; one or more second-type surface maps wherein one of the first thermodynamic engine parameter and the second thermodynamic engine parameter corresponds to a formula-derived thermodynamic engine parameter and a second of the first thermodynamic engine parameter and the second thermodynamic engine parameter corresponds to a measurable thermodynamic engine parameter, wherein a formula-derived thermodynamic engine parameter includes a thermodynamic engine parameter that is derived from a predetermined mathematical relationship between one or more measurable thermodynamic engine parameters and/or one or more estimated thermodynamic engine parameters; and one or more third-type surface maps, both the first thermodynamic engine parameter and the second thermodynamic engine parameter correspond to a formula-derived thermodynamic engine parameter or an estimated thermodynamic engine parameter.

In some aspects, the techniques described herein relate to an aerial vehicle, wherein to read the estimated parameter value the controller is configured to: read a value from each of the plurality of thermodynamic surface maps for the third thermodynamic engine parameter in a single pass with each of the plurality of thermodynamic surface maps; and use linear interpolation to estimate a value based on selected values for the first thermodynamic engine parameter and the second thermodynamic engine parameter that have been measured or calculated.

In some aspects, the techniques described herein relate to an aerial vehicle, wherein the controller is configured to capture six measurable thermodynamic engine parameters wherein a first measured parameter is a power turbine exit temperature (T5), a second measured parameter is a compressor exit static pressure (PS3), a third measured parameter is an ambient pressure (P_{amb}), a fourth measured parameter is an engine inlet temperature (T1), a fifth measured parameter is a power turbine shaft speed (NPT), and a sixth measured parameter is a flight Mach number (Mach).

In some aspects, the techniques described herein relate to an aerial vehicle, wherein the controller is configured to read: a TSbias from a first thermodynamic surface map, a P41/PS3 ratio from a second thermodynamic surface map, a P45/P41 ratio from a third thermodynamic surface map, a P45/P_{amb} ratio from a fourth thermodynamic surface map, a ratio of specific heat at constant pressure to specific heat at constant volume at station 4.5 (Gamma45) from a fifth thermodynamic surface map, a power turbine delta temperature (T45-T5) over power turbine inlet temperature (T45) ratio from a sixth thermodynamic surface map, a power turbine efficiency map relation from a seventh thermodynamic surface map, and an inter turbine temperature prediction error from an eight thermodynamic surface map.

In some aspects, the techniques described herein relate to an aerial vehicle, wherein the controller is configured to calculate: a modified power turbine exit temperature as a first calculated engine parameter; a shaft speed referred using T5 as a second calculated engine parameter (NPTRS); a ratio of power turbine inlet pressure (P45) over power turbine exit pressure (P5) as a third calculated engine parameter (P45/P5); a power turbine shaft speed referred using T45 that is represented as a percentage of 100% speed as a fourth calculated engine parameter (NPTR%); an ideal power turbine delta temperature over inlet temperature ((T45-T5_ideal)/T45) as a fifth calculated engine parameter (ideal PT_dT/T)); a sixth calculated engine parameter related to the fourth calculated engine parameter; a measure of power turbine efficiency as a seventh calculated engine parameter (PT_{eff}); and an eighth calculated engine parameter T5_term wherein T5_term = (T5 /1000) ^2 * PS3/P_{amb}.

In some aspects, the techniques described herein relate to an aerial vehicle, wherein the controller is configured to calculate the unmeasured temperature based on the sixth calculated engine parameter and the inter turbine temperature prediction error using a ninth predetermined mathematical formula, wherein the ninth predetermined mathematical formula includes T45F = T45 - 459.67, wherein T45 = T5 / Tempratio_T5/T45, and Tempratio_T5/T45 = (1 / P45/P5) ^ (PT_{eff} * (Gamma45 -1) / Gamma45).

In some aspects, the techniques described herein relate to a method in an aircraft including: receiving, during flight, a plurality of measurable thermodynamic engine parameters captured using aerial vehicle sensors; reading an estimated parameter value from each of a plurality of thermodynamic surface maps, wherein the plurality of thermodynamic surface maps have a first dimension including a first thermodynamic engine parameter, a second dimension including a second thermodynamic engine parameter, and a third dimension including a third thermodynamic engine parameter whose value is related to the first thermodynamic engine parameter and the second thermodynamic engine parameter, wherein the estimated parameter values are read from the third thermodynamic engine parameter from each of a plurality of thermodynamic surface maps based on selected values for a first thermodynamic engine parameter and a second thermodynamic engine parameter; estimating an unmeasured temperature value based on the estimated parameter values read from the plurality of thermodynamic surface maps; and controlling a turbine engine in the aircraft during a mission based on the estimated unmeasured temperature value.

Those of skill in the art will appreciate that the various illustrative logical blocks, modules, circuits, and algorithm steps described about the embodiments disclosed herein may be implemented as electronic hardware, computer software, or combinations of both. Some of the embodiments and implementations are described above in terms of functional and/or logical block components (or modules) and various processing steps. However, it should be appreciated that such block components (or modules) may be realized by any number of hardware, software, and/or firmware components configured to perform the specified functions. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention. For example, an embodiment of a system or a component may employ various integrated circuit components, e.g., memory elements, digital signal processing elements, logic elements, look-up tables, or the like, which may carry out a variety of functions under the control of one or more microprocessors or other control devices. In addition, those skilled in the art will appreciate that embodiments described herein are merely exemplary implementations.

The various illustrative logical blocks, modules, and circuits described in connection with the embodiments disclosed herein may be implemented or performed with a general-purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A method comprising:
providing a plurality of three-dimensional (3-D) thermodynamic surface maps for a plurality of stations of a gas turbine engine based on a thermodynamic engine model for the gas turbine engine, each of the plurality of thermodynamic surface maps having a first dimension comprising a first thermodynamic engine parameter, a second dimension comprising a second thermodynamic engine parameter, and a third dimension comprising a third thermodynamic engine parameter whose value is related to the first thermodynamic engine parameter and the second thermodynamic engine parameter;
capturing, during flight using aircraft sensors, a plurality of measurable thermodynamic engine parameters;
reading an estimated parameter value for the third thermodynamic engine parameter from each of the plurality of thermodynamic surface maps based on selected values for the first thermodynamic engine parameter and the second thermodynamic engine parameter;
estimating an unmeasured temperature value based on the estimated parameter values read from the plurality of thermodynamic surface maps; and
controlling the gas turbine engine during a mission based on the estimated unmeasured temperature value.

2. The method of any one of the preceding claims, wherein a thermodynamic engine parameter comprises a temperature value, a pressure value, a pressure ratio, a speed value, a specific heat ratio, a temperature difference over temperature ratio, a temperature prediction error, or a turbine efficiency * sqrt (ideal delta T/T) / %spd factor.

3. The method of any one of the preceding claims, wherein the plurality of thermodynamic surface maps comprises:
one or more first-type surface maps wherein both the first thermodynamic engine parameter corresponds to a measurable thermodynamic engine parameter and the second thermodynamic engine parameter corresponds to a measurable thermodynamic engine parameter, wherein a measurable thermodynamic engine parameter comprises a thermodynamic engine parameter that can be measured during flight using aircraft sensors;
one or more second-type surface maps wherein one of the first thermodynamic engine parameter and the second thermodynamic engine parameter corresponds to a formula-derived thermodynamic engine parameter and a second of the first thermodynamic engine parameter and the second thermodynamic engine parameter corresponds to a measurable thermodynamic engine parameter, wherein a formula-derived thermodynamic engine parameter comprises a thermodynamic engine parameter that is derived from a predetermined mathematical relationship between one or more measurable thermodynamic engine parameters and/or one or more estimated thermodynamic engine parameters; and
one or more third-type surface maps, both the first thermodynamic engine parameter and the second thermodynamic engine parameter correspond to a formula-derived thermodynamic engine parameter or an estimated thermodynamic engine parameter.

4. The method of any one of the preceding claims, wherein reading the estimated parameter value comprises reading a value from each of the plurality of thermodynamic surface maps for the third thermodynamic engine parameter in a single pass with each of the plurality of thermodynamic surface maps.

5. The method of any one of claims 1-3, wherein reading the estimated parameter value comprises using linear interpolation to estimate a value based on selected values for the first thermodynamic engine parameter and the second thermodynamic engine parameter that have been measured or calculated.

6. The method of any one of the preceding claims, wherein the plurality of measurable thermodynamic engine parameters comprises: a first measured parameter comprising a power turbine exit temperature (T5), a second measured parameter comprising a compressor exit static pressure (PS3), a third measured parameter comprising an ambient pressure (Pamb), a fourth measured parameter comprising an engine inlet temperature (T1), a fifth measured parameter comprising a power turbine shaft speed (NPT), and a sixth measured parameter comprising a flight Mach number (Mach).

7. The method of any one of the preceding claims, wherein generating a plurality of thermodynamic surface maps comprises generating at least eight different thermodynamic surface maps.

8. The method of claim 7, wherein reading the estimated parameter value for the third thermodynamic engine parameter from each of the plurality of thermodynamic surface maps comprises reading: a TSbias from a first thermodynamic surface map, a P41/PS3 ratio from a second thermodynamic surface map, a P45/P41 ratio from a third thermodynamic surface map, a P45/Pamb ratio from a fourth thermodynamic surface map, a ratio of specific heat at constant pressure to specific heat at constant volume at station 4.5 (Gamma45) from a fifth thermodynamic surface map, a power turbine delta temperature (T45-T5) over power turbine inlet temperature (T45) ratio from a sixth thermodynamic surface map, a power turbine efficiency map relation from a seventh thermodynamic surface map, and an inter turbine temperature prediction error from an eight thermodynamic surface map.

9. The method of claim 8, further comprising calculating at least eight different formula-derived thermodynamic engine parameters.

10. The method of claim 9, wherein calculating at least eight different formula-derived thermodynamic engine parameters comprises calculating: a modified power turbine exit temperature as a first calculated engine parameter; a shaft speed referred using T5 as a second calculated engine parameter (NPTRS); a ratio of power turbine inlet pressure (P45) over power turbine exit pressure (P5) as a third calculated engine parameter (P45/P5); a power turbine shaft speed referred using T45 that is represented as a percentage of 100% speed as a fourth calculated engine parameter (NPTR%); an ideal power turbine delta temperature over inlet temperature ((T45-T5_ideal)/T45) as a fifth calculated engine parameter (ideal PT_dT/T)); a sixth calculated engine parameter related to the fourth calculated engine parameter; a measure of power turbine efficiency as a seventh calculated engine parameter (PTeff); and an eighth calculated engine parameter T5_term wherein T5_term = (T5 /1000) ^2 * PS3/Pamb.

11. The method of claim 10, wherein estimating the unmeasured temperature value based on the estimated parameter values read from the plurality of thermodynamic surface maps comprises calculating the unmeasured temperature based on the sixth calculated engine parameter and the inter turbine temperature prediction error using a ninth predetermined mathematical formula.

12. The method of claim 11, wherein the ninth predetermined mathematical formula comprises T45F = T45 - 459.67, wherein T45 = T5 / Tempratio_T5/T45, and Tempratio_T5/T45 = (1 / P45/P5) ^ (PTeff * (Gamma45 -1) / Gamma45).

13. An aerial vehicle, comprising a turbine engine and a turbine engine control system, wherein the turbine engine control system comprises a controller configured to implement the steps of the method according to any one of claims 1-12.

14. A computer program product comprising program instructions, the program instructions implement the steps of the method according to any one of claims 1-12 when executed by a processor.
